Europäisches Patentamt

European Patent Office

Office européen des brevets

(11) Publication number: **0 155 117**
**B1**

(12) EUROPEAN PATENT SPECIFICATION

(45) Date of publication of patent specification: **29.08.90**

(51) Int. Cl.⁵: **G 01 R 19/165**

(21) Application number: **85301327.4**

(22) Date of filing: **27.02.85**

(54) Voltage detecting device.

(30) Priority: **28.02.84 JP 35115/84**

(43) Date of publication of application:
**18.09.85 Bulletin 85/38**

(45) Publication of the grant of the patent:
**29.08.90 Bulletin 90/35**

(84) Designated Contracting States:
**DE FR GB**

(56) References cited:
**CH-A- 615 277**
**DE-B-2 930 424**
**US-A-3 874 955**
**US-A-3 893 146**

(73) Proprietor: **FUJITSU LIMITED**
**1015, Kamikodanaka Nakahara-ku**
**Kawasaki-shi Kanagawa 211 (JP)**

(72) Inventor: **Arakawa, Hideki**
**Asahi-so 13-17, Umegaoka Midori-ku**
**Yokohama-shi Kanagawa 227 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

## Description

The present invention relates to voltage detecting devices for use, for example, in an electrically erasable and programmable read-only memory ($E^2$PROM), a nonvolatile random access memory (NOVRAM), or the like.

In such memory devices a write/erase voltage $V_{PP}$ of the order of 20 to 25 V may be used, which voltage is significantly higher than the normal power supply voltage $V_{CC}$ (for example 5 V). In a prior memory device this write/erase voltage $V_{PP}$ was supplied from an external source, but in recent years a step-up circuit has been provided in a chip, incorporating a memory device, to generate an internal write/erase voltage (IVP). In this way the number of external power supplies and external terminals (pads) of the chip can be reduced.

During operation in a write/erase mode, a clock signal is supplied to the step-up circuit, thereby causing the write/erase voltage IVP to increase. The resulting stepped-up voltage IVP is applied to a selected memory cell in order to perform a write/erase operation thereupon by means of the tunnelling effect. In this case, however, a write/erase voltage detecting device is required for detecting the magnitude of the write/erase voltage IVP so as to prevent the voltage applied to the memory cell from being higher than a predetermined admissible value.

This is necessary because application of a write/erase voltage IVP higher than the aforesaid predetermined value to the cell may destroy or reduce the operating life-time of that cell.

One form of prior art voltage detecting device includes a voltage dividing circuit, formed by two capacitors connected together in series at a common node, and an inverter circuit for detecting whether the potential at the common node of the capacitors reaches a predetermined value. Because such an inverter circuit is suitable only for detecting relatively low voltages, the relatively high applied input voltage IVP must first be reduced to a relatively low voltage by the dividing circuit, in order that this relatively high voltage IVP can be detected indirectly by the inverter circuit.

In the above-described voltage detecting device, the capacitor that directly receives the applied voltage IVP conventionally consists of two polycrystalline silicon layers having a silicon dioxide layer sandwiched therebetween, the silicon dioxide layer having been formed by oxidizing one of the polycrystalline silicon layers. However such a silicon dioxide layer has a relatively low threshold electric field strength for tunnelling, such as 1 to 3 MV/cm, so that the silicon dioxide layer has to be made thick if serious tunnelling effects are to be avoided, thereby increasing the dimensions of the capacitor. Any residual tunnelling effects can cause charges at the common node of the capacitors to leak, so that the potential at the node is changed. In addition, traps are formed in the silicon dioxide layer obtained by oxidizing polycrystalline silicon, and charges trapped thereat can also affect the potential at the common node. Variations in the initial potential at this node when a measurement is initiated can affect in turn the dividing ratio of the voltage dividing circuit, so that the ensuing measurement is not desirably accurate.

Furthermore, the above-mentioned tunnelling and charge trap problems can also arise, albeit generally to a lesser degree, in diffusion-type capacitors that include an oxide layer formed by oxidizing a monocrystalline silicon layer, for example.

Accordingly, the above-described form of voltage detecting device may not detect precisely when the applied high voltage IVP reaches the aforementioned predetermined admissible value.

According to the present invention, there is provided a voltage detecting device, for monitoring the magnitude of an input voltage, including voltage dividing circuitry comprising first and second capacitors, each of the type employing an oxide layer as the capacitor's dielectric, which capacitors are connected in series with one another, through a common node, between a reference voltage line and an input point to which the said input voltage is applied when the device is in use, and also including voltage detecting means, connected to the said common node, for generating an output signal when the potential at the said common node reaches a predetermined value, characterised in that the voltage detecting device further includes switching means arranged and connected so as to provide a conductive connection between the said common node and the reference voltage line when such monitoring is not required.

Reference will now be made, by way of example, to the accompanying drawings, wherein:-

Fig. 1 is a schematic block diagram of an example of a memory device to which the present invention can be applied;

Fig. 2 is a circuit diagram of a prior art voltage detecting device;

Fig. 3 is a graph illustrating the operation of the voltage detecting device of Fig. 2;

Fig. 4 is a cross-sectional view of a voltage dividing portion of the device of Fig. 2;

Fig. 5 is a circuit diagram of a voltage detecting device embodying the present invention; and

Fig. 6 is a cross-sectional view of part of the device of Fig. 5.

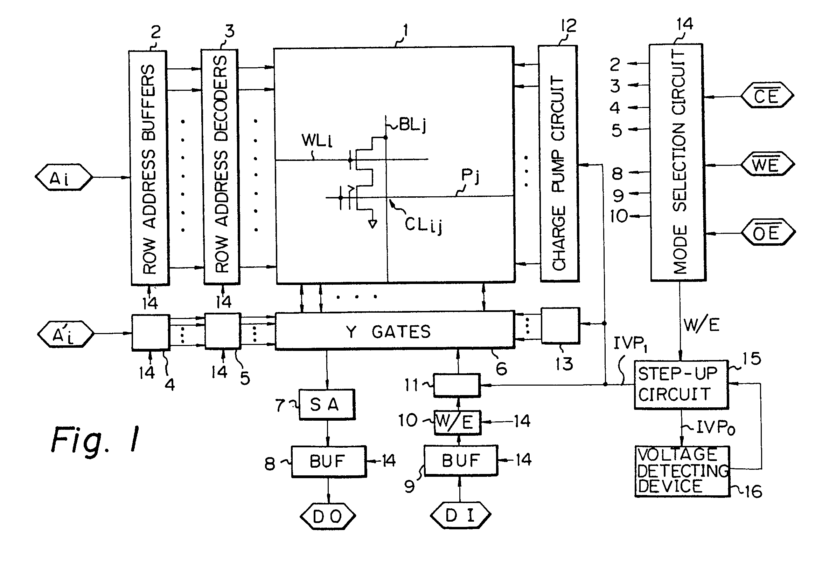

Figure 1 shows an electrically erasable and programmable read-only memory ($E^2$PROM) including a memory cell array 1 of memory cells CL. For example, a memory cell $CL_{ij}$ is provided at an intersection between a word line $W_i$ and a bit line $BL_j$. $P_j$ designates a program line. The $E^2$PROM also comprises row address buffers 2 each receiving an X-address signal $A_i$ (i = 0 to n), row address decoders 3, column address buffers 4 each receiving a Y-address signal $A_i'$ (i = 0 to n), column address decoders 5 and Y-gates 6. Output data is transmitted from the Y-gates 6 via a sense amplifier 7 and an output data buffer 8 to an output terminal DO, while input data is supplied from an input terminal DI via an input data buffer/latch circuit 9, a write/erase control circuit 10, and a charge pump circuit 11 to the Y-gates 6.

The memory device further includes a mode selection circuit 14 which receives a chip-enable signal $\overline{CE}$, a write-enable signal $\overline{WE}$, an output-enable signal $\overline{OE}$, and other control signals, and selects a mode of operation of the device in accordance with those signals by controlling the elements 2, 3, 4, 5, 8, 9, and 10 as appropriate.

A step-up circuit 15 is included in the E²PROM for generating a rising write/erase voltage $IVP_1$ during a write/erase mode (W/E = "1"). The memory device also comprises a voltage detecting device 16 which is connected to receive an output voltage $IVP_0$ from a "monitor" output of the step-up circuit 15 so as to detect the point in time at which that voltage $IVP_0$ reaches a predetermined value. The monitored output voltage $IVP_0$ is of a magnitude approximately equal to that of the actual write/erase voltage $IVP_1$, thereby enabling detection of the point at which the actual write/erase voltage $IVP_1$ reaches the aforesaid predetermined admissible value.

The write/erase voltage $IVP_1$ is applied to the charge pump circuits 11, 12, and 13.

A writing operating for the memory cell $CL_{ij}$ is carried out by applying a high voltage (20 V to 25 V) to the word line $WL_i$ and to the program line $P_j$. Generally, in an E²PROM a "writing operation" denotes the operation of writing the data "1" into a cell, and an "erasing operation" denotes the operation of writing the data "0" into a cell. The read operation for the memory cell $C_{ij}$ is carried out by applying a power supply voltage $V_{cc}$ (= 5 V) to the word line $WL_i$ and applying a predetermined bias voltage (about 2 V) to the program line $P_j$.

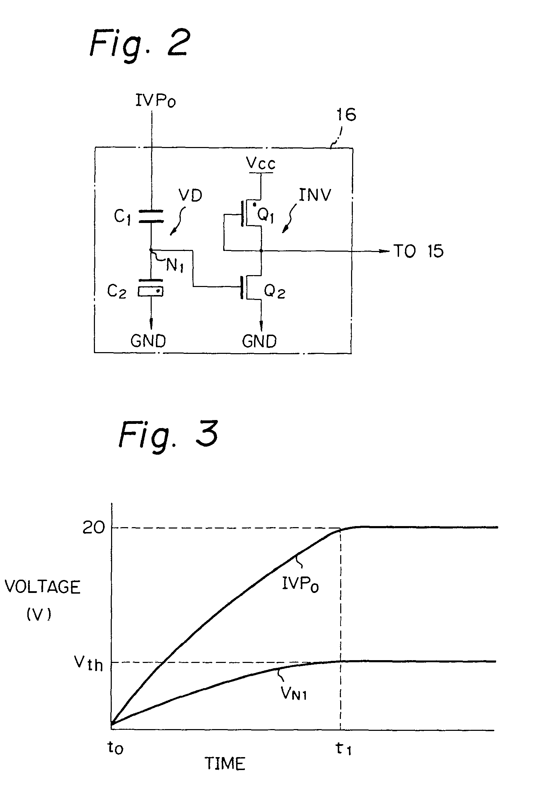

The voltage detecting device 16 shown in Fig. 2 includes a voltage dividing circuit VD, formed by connecting in series capacitors $C_1$ and $C_2$, and an inverter circuit INV comprising a depletion-type transistor $Q_1$ and an enhancement-type transistor $Q_2$.

Note that $V_{cc}$ designates a power supply voltage such as 5 V, and GND designates a reference potential such as 0 V, available at a "ground", or earth line of the circuit.

In the device of Fig. 2, when the write/erase voltage $IVP_0$ rises as illustrated in Fig. 3, the potential $V_{N1}$ at the node $N_1$ also rises in proportion thereto, in accordance with the relation

$$V_{N1} \frac{C_1}{C_1 + C_2} IVP_0$$

As a result, at time $t_1$ the potential $V_{N1}$ reaches the threshold voltage $V_{th}$ of the inverter INV (which threshold voltage is the same as the threshold voltage of the transistor $Q_2$), thereby changing the output potential of the inverter INV from a high level to a low level.

The output signal of the voltage detecting device, i.e., the output potential of the inverter circuit INV, is supplied to the step-up circuit 15 of Fig. 1, which is also connected to receive at an input the write/erase signal W/E from the mode selection circuit 14. When the output potential of the voltage detecting device 16 becomes low the W/E input of the step-up circuit 15 is inhibited, thereby preventing any further rise in the potential of the write/erase voltage $IVP_1$. Thus, the write/erase voltage $IVP_1$ never becomes higher than a predetermined admissible value, such as 20 V.

Note that it is impossible to detect the write/erase voltage $IVP_0$ directly using the inverter circuit INV, since the threshold voltage $V_{th}$ of the inverter circuit INV is inherently low and, in the case when $V_{cc}$ = 5 V for example, is at most 3 V to 4 V. In order to reduce the write/erase voltage $IVP_0$ to a value comparable to that of the threshold voltage $V_{th}$ of the inverter circuit INV, the above-mentioned voltage dividing circuit VD is provided. By virtue of its capacitive configuration, the voltage dividing circuit VD has the advantage that no direct current loss is involved.

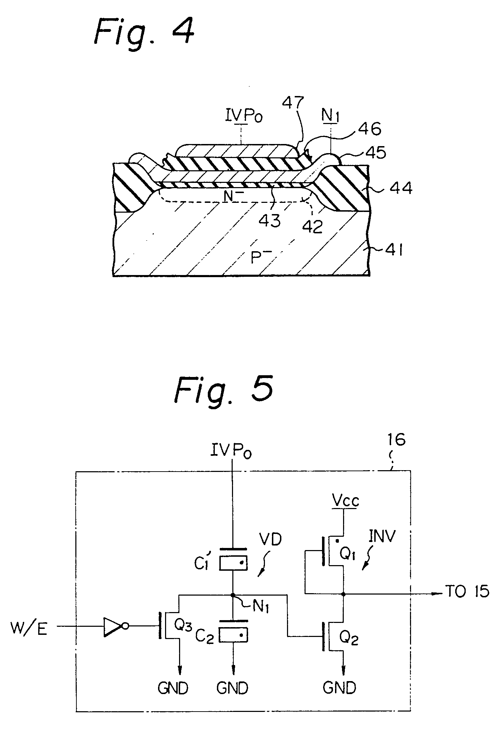

Figure 4 shows one form of construction of the voltage dividing circuit VD of Fig. 2 manufactured using so-called "double-layer polycrystalline silicon technology". In Fig. 4, reference numeral 41 designates a P⁻-type monocrystalline silicon substrate having an N⁻-type impurity diffusion region 42 therein. A thin insulating layer 43 of silicon dioxide ($SiO_2$) and a thick insulating layer 44 (field oxide layer, also of $SiO_2$) are both formed by oxidizing the monocrystalline silicon substrate 41. A first polycrystalline silicon layer 45, a relatively thick insulating layer ($SiO_2$) 46, and a second polycrystalline silicon layer 47 are formed in succession on the oxide layer 43. The relatively thick insulating layer 46 is formed by oxidizing the first polycrystalline silicon layer 45. The capacitor $C_1$ of Fig. 2 is thus constituted by the first polycrystalline silicon layer 45, the second polycrystalline silicon layer 47, and the insulating layer 46 therebetween, while the capacitor $C_2$ is constituted by the N⁻-type diffusion layer 42, the first polycrystalline silicon layer 45, and the insulating layer 43 therebetween. Since the voltage division ratio of the voltage dividing circuit VD is chosen to be 10 for example, at an applied write/erase voltage $IVP_0$ of 20 V, the potential at the common node $N_1$ is only 2 V, so that most of the write/erase voltage $IVP_0$ is developed across the capacitor $C_1$ rather than the capacitor $C_2$. In this respect, since the insulating layer 46 obtained by the oxidation of polycrystalline silicon has a lower threshold electric field strength for tunnelling (1 to 3 MV/cm) than that of an oxide layer produced by oxidizing a monocrystalline silicon layer (5 to 7 MV/cm), the layer 46 has to be relatively thick so as to avoid serious tunnelling effects, thereby increasing the dimensions of the capacitor $C_1$. None the less, some charges are unavoidably injected towards the node $N_1$ due to the tunnelling effect, because, as explained above, most of the relatively high applied voltage is developed across the insulating layer 46 of the capacitor $C_1$. In this case, electrons are emitted from the first polycrystalline silicon layer 45 via the insulating layer 46 to the second polycrystalline silicon layer 47. Accordingly, holes remain semi-permanently at the first polycrystalline silicon layer 45, since the layer 45 is in an electrically-floating state. As a result, the potential at the node $N_1$ increases, causing the inverter to switch to a low potential too early, so that the write/erase voltage $IVP_0$ is prevented from rising to its intended value.

In addition, the polycrystalline silicon oxidized layer in particular, and, to a lesser extent, the monocrystalline silicon oxidized layer contain traps. Charges trapped at such traps also may affect the potential at node $N_1$.

The voltage detecting device of Fig. 5 includes a capacitor $C_1'$ in place of the capacitor $C_1$ of Fig. 2, and a switching transistor $Q_3$ connected between the node $N_1$ and ground GND. This switching transistor $Q_3$ can be controlled by the write/erase signal W/E from the mode selection circuit 14. In this way, in a write/erase mode during which the signal W/E is at a high level (= "1"), the switching transistor $Q_3$ is turned on. In the embodiment of the invention shown in Fig. 5, the capacitor $C_1'$ employs an insulating layer obtained by oxidizing monocrystalline silicon. In the absence of the transistor $Q_3$, when the write/erase voltage $IVP_0$ is changed from the high level to the low level (at the end of a write/erase operation), the potential at the node $N_1$ would swing towards a negative voltage due to junction leak. However, the potential at the node $N_1$ never becomes negative due to the presence of the transistor $Q_3$, which is turned on at this point. Furthermore, even when the transistor $Q_3$ is in the off state, the potential at the node $N_1$ cannot be lower than the negative value of the threshold voltage of the transistor $Q_3$ (−0.6 V, for example).

Moreover, even when a reverse bias such as −5 V is applied to the substrate, the potential at the node $N_1$ is never swung towards that reverse bias if the write/erase signal W/E is at the "0" state.

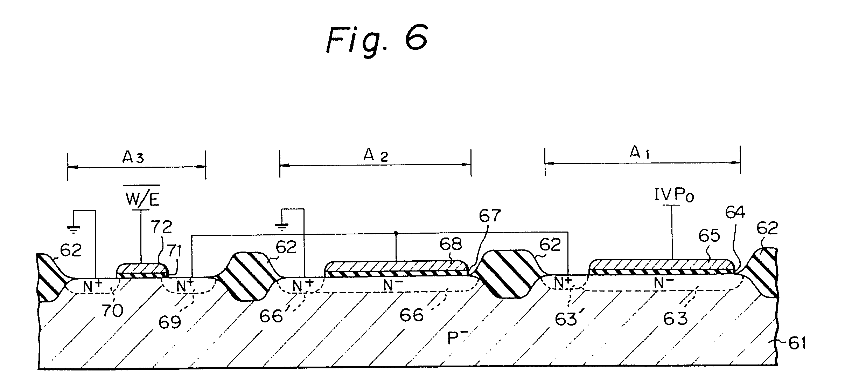

In Fig. 6, which is a cross-sectional view of the voltage dividing circuit VD and the switching transistor $Q_3$ of Fig. 5, reference numeral 61 designates a monocrystalline silicon substrate; 62 a thick insulating layer (field layer of $SiO_2$); 63 and 66 $N^-$-type impurity diffusion regions; 63', 66', 69, and 70 $N^+$-type impurity diffusion regions; 64, 67, and 71 thin insulating oxide layers ($SiO_2$); and 65, 68, and 72 polycrystalline silicon layers. All the insulating layers are obtained by oxidizing the monocrystalline silicon substrate 61.

In Fig. 6, active areas $A_1$, $A_2$, and $A_3$ are defined by gaps in the field layer 62. The capacitor $C_1'$ is formed in the area $A_1$, the capacitor $C_2$ is formed in the area $A_2$, and the switching transistor $Q_3$ is formed in the area $A_3$. The capacitor $C_1'$ is constituted by the diffusion region 63 within the substrate 61, the polycrystalline silicon layer 65 to which the write/erase voltage $IVP_0$ is applied, and the oxide layer 64 therebetween. The capacitor $C_2$ in the area $A_2$ is constituted by the impurity diffusion region 66 within the substrate 61, the polycrystalline silicon layer 68, and the oxide layer 67 therebetween. In this case, note that the polycrystalline silicon layer 68 is connected to the diffusion region 63 via the diffusion region 63', and the diffusion region 68 is grounded by the diffusion region 66'. Further, in the area $A_3$, the switching transistor $Q_3$ is formed by the diffusion regions 69 and 70, and the polycrystalline silicon layer 72 to which the write/erase signal W/E is applied, and the insulating layer 71 directly below the polycrystalline silicon layer 72. In this case, note that the diffusion region 70 is grounded.

In Fig. 6, the voltage dividing ratio of the voltage dividing circuit VD is substantially the same as the ratio of the respective areas of the polycrystalline silicon layers 65 and 68 which area, ratio can be easily determined by lithography techniques.

In a further embodiment of the invention the capacitor $C_1'$ can be constructed by using a polycrystalline silicon — silicon dioxide — polycrystalline silicon configuration. In this case, when the write/erase voltage $IVP_0$ is changed from the high level to the low level, the potential at the node $N_1$ has a tendency to swing towards a positive voltage due to the tunnelling effect. However, the potential at the node $N_1$ never actually becomes positive due to the presence of the on-state transistor $Q_3$.

Further, the capacitor $C_2$ can be constructed by using a polycrystalline silicon — silicon dioxide — polycrystalline silicon configuration, since the voltage developed across the capacitor $C_2$ is small and, accordingly, no appreciable tunnelling effect occurs in the capacitor $C_2$.

In view of the required accuracy of the voltage dividing ratio, it is preferable to use a capacitor $C_2$ of the same configuration as the capacitor $C_1'$, since in this case, a particular desired voltage dividing ratio may be easily obtained, being substantially the same as the ratio of the respective areas of the capacitors $C_1'$ and $C_2$, as mentioned above.

As described above, the voltage detecting device according to the invention includes voltage dividing circuitry, comprising capacitors connected together in series at a common node, and switching means for selectively providing a conductive connection between the common node and ground. Since the common node of the capacitors is grounded by the switching means when monitoring of an applied voltage is not required, the potential at the node is always reset before a measurement is initiated. This enables the applied voltage to be detected with greater accuracy, so that when, for example, the voltage detecting device is employed in a memory device such as an $E^2PROM$ or NOVRAM, a write/erase voltage of a suitable magnitude can be obtained.

**Claims**

1. A voltage detecting device, for monitoring the magnitude of an input voltage ($IVP_0$), including voltage dividing circuitry comprising first and second capacitors ($C_1'$, $C_2$), each of the type employing an oxide layer as the capacitor's dielectric, which capacitors are connected in series with one another, through a common node ($N_1$), between a reference voltage line (GND) and an input point to which the said input voltage ($IVP_0$) is applied when the device is in use, and also including voltage detecting means (INV), connected to the said common node ($N_1$), for generating an output signal when the potential at the said common node ($N_1$) reaches a predetermined value, characterised in that the voltage detecting device further includes switching means ($Q_3$) arranged and connected so as to provide a conductive connection between the said common node ($N_1$) and the reference voltage line (GND) when such monitoring is not required.

2. A device as set forth in claim 1, wherein said first capacitor ($C_1'$) comprises a monocrystalline silicon layer (61), a silicon dioxide layer (64) obtained by oxidizing said monocrystalline silicon layer (61), and a polycrystalline silicon layer (65) formed on said silicon dioxide layer.

3. A device as set forth in claim 2, wherein said second capacitor ($C_2$) comprises a second silicon dioxide layer (67) obtained by oxidizing said monocrystalline silicon layer (61), and a second polycrystalline silicon layer (68) formed on said second silicon dioxide layer.

4. A device as set forth in claim 1, wherein said first capacitor ($C_1'$) comprises first and second polycrystalline silicon layers having therebetween a silicon dioxide layer formed by oxidizing the said first polycrystalline silicon layer.

5. A device as set forth in claim 2 or 4, wherein said second capacitor ($C_2$) comprises two polycrystalline silicon layers having therebetween a second silicon dioxide layer formed by oxidizing one of those polycrystalline silicon layers.

6. A device as set forth in claim 4, wherein said second capacitor ($C_2$) comprises a second silicon dioxide layer (43), sandwiched between the said first polycrystalline silicon layer (45) and a monocrystalline silicon layer (41) on which the said second silicon dioxide layer hasbeen formed by oxidation.

7. A voltage detecting device as set forth in any preceding claim, wherein the voltage detecting means comprise an inverter (INV).

**Patentansprüche**

1. Spannungsdetektoreinrichtung zur überwachung der Größe einer Eingangsspannung ($IVP_0$), die eine Spannungsteilerschaltung enthält, die erste und zweite Kondensatoren ($C_1'$, $C_2$) umfaßt, jeweils von dem Typ, der eine Oxidschicht als Dielektrikum des Kondensators verwendet, welche Kondensatoren in Reihe miteinander verbunden sind, über einen gemeinsamen Knoten ($N_1$), zwischen einer Referenzspannungsleitung (GND) und einem Eingangspunkt, an dem die genannte Eingangsspannung ($IVP_0$) aufgebracht wird, wenn die Einrichtung in Betrieb ist, und die ferner eine Spannungsdetektorvorrichtung (INV) enthält, die mit dem genannten gemeinsamen Knoten ($N_1$) verbunden ist, um ein Ausgangssignal zu erzeugen, wenn das Potential an dem genannten gemeinsamen Knoten ($N_1$) einen vorbestimmten Wert erreicht, dadurch gekennzeichnet, daß die Spannungsdetektoreinrichtung ferner eine Schalteinrichtung ($Q_3$) umfaßt, die angeordnet und so verbunden ist, daß sie eine leitende Verbindung zwischen dem genannten gemeinsamen Knoten ($N_1$) und der Referenzspannungsleitung (GND) liefert, wenn solch eine überwachung nicht erfordert ist.

2. Einrichtung nach Anspruch 1, bei der der genannte erste Kondensator ($C_1'$) eine monokristalline Siliciumschicht (61), eine Siliciumdioxidschicht (64), die durch Oxidieren der genannten monokristallinen Siliciumschicht (61) erhalten wurde, und eine polykristalline Siliciumschicht (65) umfaßt, die auf der genannten Siliciumdioxidschicht gebildet ist.

3. Einrichtung nach Anspruch 2, bei der der genannte zweite Kondensator ($C_2$) eine zweite Siliciumdioxidschicht (67) umfaßt, die durch Oxidieren der genannten monokristallinen Siliciumschicht (61) erhalten wurde, und eine zweite polykristalline Siliciumschicht (68), die auf der genannten zweiten Siliciumdioxidschicht gebildet ist.

4. Einrichtung nach Anspruch 1, bei der der genannte erste Kondensator ($C_1'$) erste und zweite polykristalline Siliciumschichten umfaßt, zwischen denen durch Oxidation der genannten ersten polykristallinen Siliciumschicht eine Siliciumdioxidschicht gebildet ist.

5. Einrichtung nach einem der Ansprüche 2 oder 4, bei der der genannte zweite Kondensator ($C_2$) zwei polykristalline Siliciumschichten umfaßt, die zwischen einander eine zweite Siliciumdioxidschicht haben, die durch Oxidieren einer von jenen polykristallinen Siliciumschichten gebildet ist.

6. Einrichtung nach Anspruch 4, bei der der genannte zweite Kondensator ($C_2$) eine zweite Siliciumdioxidschicht (43) umfaßt, die sandwichartig zwischen der genannten ersten polykristallinen Siliciumschicht (45) und einer monokristallinen Siliciumschicht (41) angeordnet ist, auf der die genannte zweite Siliciumdioxidschicht durch Oxidation gebildet worden ist.

7. Spannungsdetektoreinrichtung nach einem der vorhergehenden Ansprüche, bei der die genannte Spannungsdetektorvorrichtung einen Inverter (INV) umfaßt.

**Revendications**

1. Dispositif détecteur de tension pour surveiller l'amplitude d'une tension d'entrée ($IVP_0$), qui comprend un circuit diviseur de tension comprenant des première et seconde capacités ($C_1'$, $C_2$), chacune du type utilisant une couche d'oxyde comme diélectrique de la capacité, lesquelles capacités sont branchées en série l'une avec l'autre, par l'intermédiaire d'un noeud commun ($N_1$), entre une ligne de tension de référence (GND) et un point d'entrée au niveau duquel est appliquée ladite tension d'entrée ($IVP_0$) lorsque le dispositif fonctionne, et comprenant aussi un moyen détecteur de tension (INV), relié audit noeud commun ($N_1$), pour produire un signal de sortie lorsque le potentiel audit noeud commun ($N_1$) atteint une valeur prédéterminée, caractérisé en ce que le dispositif détecteur de tension comprend en outre un moyen de commutation ($Q_3$) disposé et branché de façon à fournir une connexion conductrice entre ledit noeud commun ($N_1$) et la ligne de tension de référence (GND) lorsqu'une telle surveillance n'est pas nécessaire.

2. Dispositif selon la revendication 1, dans lequel ladite première capacité ($C_1'$) comprend une couche de silicium monocristallin (61) une couche de dioxyde de silicium (64) obtenue par oxydation de ladite couche de silicium monocristallin (61) et une couche de silicium polycristallin (65) formée sur ladite couche de dioxyde de silicium.

3. Dispositif selon la revendication 2, dans lequel ladite seconde capacité ($C_2$) comprend une seconde couche de dioxyde de silicium (67) obtenue par oxydation de ladite couche de silicium monocristallin (61) et une seconde couche de silicium polycristallin (68) formée sur ladite seconde couche de dioxyde de silicium.

4. Dispositif selon la revendication 1, dans lequel ladite première capacité ($C_1'$) comprend des première et seconde couches de silicium polycristallin entre lesquelles une couche de dioxyde de silicium est formée par oxydation de ladite première couche de silicium polycristallin.

5. Dispositif selon la revendication 2 ou 4, dans lequel ladite seconde capacité ($C_2$) comprend deux couches de silicium polycristallin entre lesquelles une seconde couche de dioxyde de silicium est formée par oxydation de l'une de ces couches de silicium polycristallin.

6. Dispositif selon la revendication 4, dans lequel ladite seconde capacité ($C_2$) comprend une seconde couche de dioxyde de silicium (43) disposée entre ladite première couche de silicium polycristallin (45) et une couche de silicium monocristallin (41) sur laquelle ladite seconde couche de dioxyde de silicium a été formée par oxydation.

7. Dispositif détecteur de tension selon l'une quelconque des revendications précédentes, dans lequel le moyen détecteur de tension comprend un inverseur (INV).

Fig. 1

*Fig. 2*

IVP₀

16

Vcc

VD

C₁

Q₁

INV

N₁

TO 15

C₂

Q₂

GND

GND

*Fig. 3*

20

VOLTAGE
(V)

IVP₀

Vth

V_N1

t₀

t₁

TIME

## Fig. 4

## Fig. 5

Fig. 6